# EUROPEAN PATENT SPECIFICATION

(11) **EP 0 813 932 B1**
(45) Date of publication and mention of the grant of the patent: **24.10.2001**
(21) Application number: 97110228.0
(22) Date of filing: 23.06.1997
(51) Int. Cl.: B24B 37/04

(54) **Polishing apparatus having a cloth cartridge**
Poliervorrichtung ausgerüstet mit Tuchkassette
Dispositif de polissage muni d'une cassette avec toile

(30) Priority: 21.06.1996 JP 18147196
(43) Date of publication of application: 29.12.1997
(73) Proprietor: EBARA CORPORATION, Ohta-ku, Tokyo (JP)
(72) Inventor: Kimura, Norio, Fujisawa-shi, Kanagawa-ken (JP); Ishii, You, Fujisawa-shi, Kanagawa-ken (JP)
(74) Representative: Wagner, Karl H., Dipl.-Ing.

(56) References cited:
- EP-A- 0 706 856
- WO-A-96/07508
- DE-A- 19 538 991
- US-A- 4 918 872

## Description

### BACKGROUND OF THE INVENTION

### Field of the Invention:

The present invention relates to a polishing apparatus for polishing a workpiece such as a semiconductor wafer, and more particularly to a polishing apparatus having a cloth cartridge which is detachably exchangeably mounted on a turntable.

### Description of the Related Art:

Recent rapid progress in semiconductor device integration demands smaller and smaller wiring patterns or interconnections and also narrower spaces between interconnections which connect active areas. One of the processes available for forming such interconnection is photolithography. Though the photolithographic process can form interconnections that are at most 0.5 µm wide, it requires that surfaces on which pattern images are to be focused by a stepper be as flat as possible because the depth of focus of the optical system is relatively small.

It is therefore necessary to make the surfaces of semiconductor wafers flat for photolithography. One customary way of flattening the surfaces of semiconductor wafers is to polish them with a polishing apparatus, and such a process is called Chemical Mechanical Polishing (CMP) in which the semiconductor wafers are chemically and mechanically polished while supplying an abrasive liquid comprising abrasive grains and chemical solution such as alkaline solution.

Conventionally, a polishing apparatus has a turntable and a top ring which rotate at respective individual speeds. A polishing cloth is attached to the upper surface of the turntable. A semiconductor wafer to be polished is placed on the polishing cloth and clamped between the top ring and the turntable. An abrasive liquid containing abrasive grains is supplied onto the polishing cloth and retained on the polishing cloth. During operation, the top ring exerts a certain pressure on the turntable, and the surface of the semiconductor wafer held against the polishing cloth is therefore polished by a combination of chemical polishing and mechanical polishing to a flat mirror finish while the top ring and the turntable are rotated.

After, for example, one or more semiconductor wafers have been polished, the polishing cloth is processed to recover its original polishing capability. Various processes have been and are being developed for restoring the polishing cloth, and are collectively called "dressing". The polishing cloth is dressed by a dressing tool in order to enable the polishing apparatus to perform a good polishing function at all times without undesired degradation of a polishing performance.

That is, a number of polishing processes are performed on the polishing cloth and a number of dressing processes are applied to the dressing cloth to thus cause the polishing cloth to be worn down, and hence the polishing cloth has to be replaced with a new one periodically. When replacing the polishing cloth, the polishing apparatus is shut down, and the polishing cloth is detached from the turntable. Thereafter, an abrasive liquid remaining on the turntable is washed out, and a new polishing cloth is attached to the turntable after drying the turntable. This maintenance work is troublesome and requires a long period of time during which the polishing apparatus continues to be shut down, thus lowering the productivity of the semiconductor devices per unit time.

In order to solve the above problems, there has been proposed a cloth cartridge which is detachably exchangeably mounted on the turntable. When a polishing cloth is worn down and required to be replaced, the cloth cartridge which has a polishing cloth mounted on a base plate and can be easily detached from the turntable is replaced with a new one which can be easily mounted on the turntable. Thus, the time required for replacement of the polishing cloth is relatively short, and the stopping time of the polishing apparatus can be shortened to thus increase the productivity of the semiconductor devices per unit time.

However, the conventional cloth cartridge has a relatively large outer diameter and is difficult to be handled. To be more specific, the cloth cartridge normally has a diameter of 600mm or more, and hence the replacement of the cloth cartridge involves removal of a disk-shaped object having a diameter of 600mm or more from the polishing apparatus. In many cases, the polishing apparatus is installed in a clean room, and when the cloth cartridge is replaced, the polishing cloth is normally wet with an abrasive liquid and such condition of the polishing cloth is not suitable for environment of the clean room. In order to prevent the cloth cartridge from being exposed to the environment of the clean room, the cloth cartridge is packed in a bag or wrapped by a sheet inside the polishing apparatus, and then the packed or wrapped cloth cartridge is taken out from the polishing apparatus. In this case, since the cloth cartridge has a large diameter and the replacement work of the cloth cartridge has to be performed in a narrow space in the polishing apparatus, handling of the cloth cartridge is troublesome and the replacement work is time-consuming.

Polishing apparatus and, respectively, cloth cartridges according to the preambles of claims 1, 5, 9 and 10 are known, for example, from DE-A-195 38 991.

### SUMMARY OF THE INVENTION

It is therefore an object of the invention to provide a polishing apparatus having a cloth cartridge which can be easily handled when replacing the cloth cartridge.

The invention is defined in claims 1, 5, 9 and 10, respectively.

The present invention will become apparent from the following description when taken in conjunction with the accompanying drawings which illustrate preferred embodiments of the present invention by way of examples.

### BRIEF DESCRIPTION OF THE DRAWINGS

FIG. 1 is a cross-sectional view of a polishing apparatus having a cloth cartridge according to an embodiment of the present invention;
FIG. 2A is an exploded perspective view of a cloth cartridge shown in FIG. 1;
FIG. 2B is a plan view of a cloth cartridge shown in FIG. 1; and
FIG. 3 is a perspective view of a cloth cartridge in the polishing apparatus according to another embodiment of the present invention.

### DETAILED DESCRIPTION OF THE PREFERRED EMBODIMENT

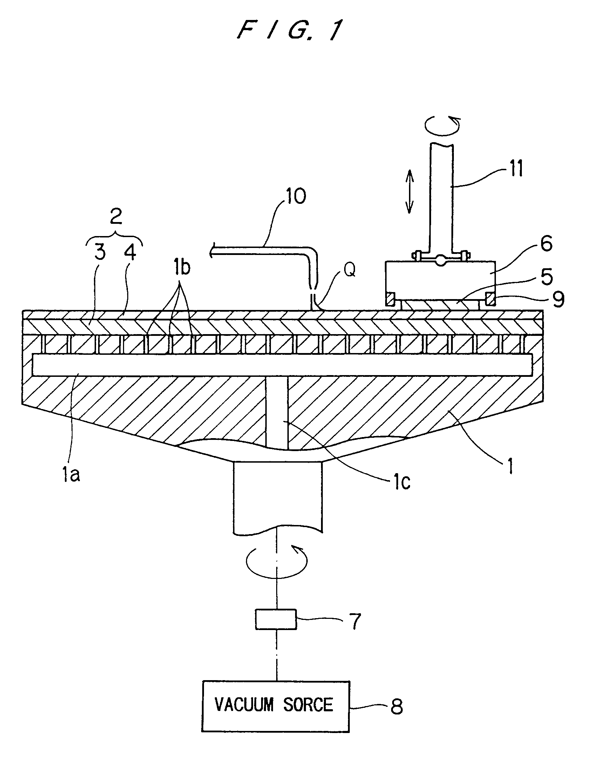

A polishing apparatus according to an embodiment of the present invention will be described below with reference to FIGS. 1 through 2B.

As shown in FIG. 1, a polishing apparatus comprises a turntable 1, a cloth cartridge 2 detachably exchangeably mounted on the turntable 1, and a top ring 6 for holding a semiconductor wafer 5 as a workpiece and pressing the semiconductor wafer 5 against the turntable 1. The cloth cartridge 2 comprises a disk-shaped base plate 3 and a polishing cloth 4 bonded to an upper surface of the base plate 3. The base plate 3 constitutes a cartridge base member.

The turntable 1 has a chamber la therein, and a number of vertical suction holes 1b which are open at the upper surface of the turntable 1 and communicate with the chamber 1a. The chamber la communicates with a vacuum source 8 through a vertical hole 1c formed in the turntable 1 and a rotary joint 7 coupled to a shaft of the turntable 1. Therefore, the cloth cartridge 2 can be fixedly mounted on the turntable 1 under vacuum developed by the vacuum source 8 when the suction holes 1b communicate with the vacuum source 8. The cloth cartridge 2 can be detached from the turntable 1 when vacuum in the suction holes 1b is broken, i.e., the pressure in the suction holes 1b is raised to ambient. The base plate 3 of the cloth cartridge 2 is made of alloy steel such as stainless steel, aluminum or plastics as a main component. The polishing cloth 4 of the cloth cartridge 2 is a commercially available polishing cloth which is normally used to polish semiconductor wafers. Examples of the polishing cloth are Suba 800 and IC-1000 manufactured by Rodel Products Corporation and Surfin xxx-5 and Surfin 000 manufactured by Fujimi Inc. The polishing cloth sold under the trade names Suba 800, Surfin xxx-5, and Surfin 000 is made of non-woven fabric composed of fibers bound together by urethane resin, and the polishing cloth sold under the trade name IC-1000 is made of polyurethane foam which is porous and has minute recesses or micropores in its surface.

The turntable 1 is rotatable about its own axis as indicated by an arrow by a motor (not shown) which is coupled to the turntable 1. The top ring 6 is coupled to a motor (not shown) and also to a lifting/lowering cylinder (not shown). The top ring 6 is vertically movable and rotatable about its own axis, as indicated by the arrows, by the motor and the lifting/lowering cylinder. The top ring 6 can therefore press the semiconductor wafer 5 against the polishing cloth 4 under a desired pressure. The semiconductor wafer 5 is attached to a lower surface of the top ring 6 under a vacuum or the like. A guide ring 9 is mounted on the outer circumferential edge of the lower surface of the top ring 6 for preventing the semiconductor wafer 5 from being disengaged from the top ring 6. An abrasive liquid Q is supplied through a supply pipe 10 onto the polishing cloth 4.

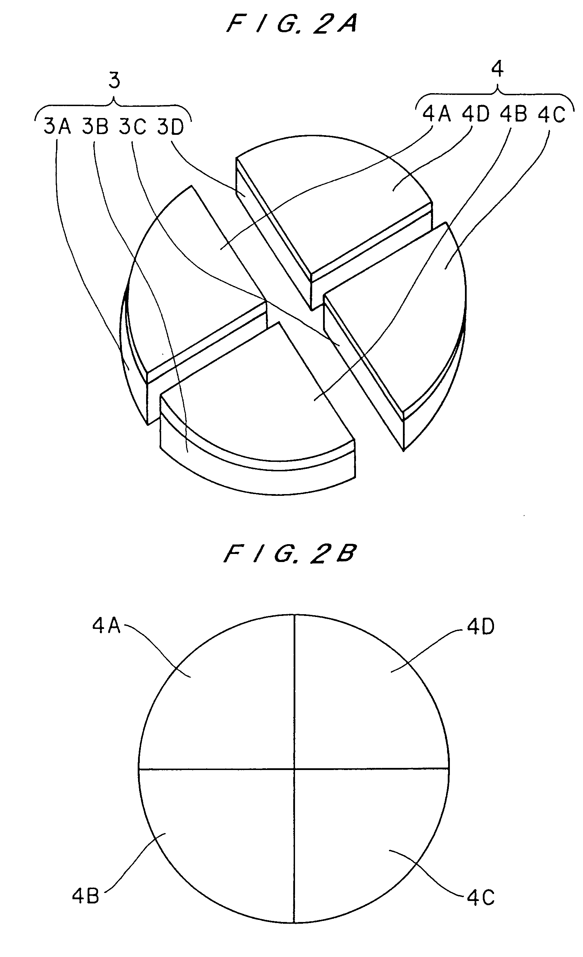

FIGS. 2A and 2B show the detailed structure of the cloth cartridge 2 shown in FIG. 1. As shown in FIGS. 2A and 2B, the cloth cartridge 2 is divided into four segments. Specifically, the base plate 3 comprises four sectorial base plate segments 3A, 3B, 3C and 3D, and the polishing cloth 4 comprises four sectorial polishing cloth segments 4A, 4B, 4C and 4D. In the division-type cloth cartridge 2, each unit comprises one of the base plate segments 3A, 3B, 3C and 3D and one of the polishing cloth segments 4A, 4B, 4C and 4D bonded to one of the base plate segments 4A, 4B, 4C and 4D. The division-type cloth cartridge 2 is detachably mounted on the upper surface of the turntable 1 under vacuum. The cloth cartridge 2 can be fixedly mounted on the turntable 1 or detached from the turntable 1 by an individual unit comprising one of the base plate segments 3A, 3B, 3C and 3D and one of the polishing cloth segments 4A, 4B, 4C and 4D. This structure of the cloth cartridge 2 allows the replacement work of the cloth cartridge 2 to be easy, and further allows the size of the bag for containing the cloth cartridge to be small. To be more specific, a bag having dimensions of 600mm x 600mm or larger is required for containing the conventional cloth cartridge therein. However, in this embodiment, a bag having dimensions of 300mm x 300mm is sufficient for containing the cloth cartridge 2 therein.

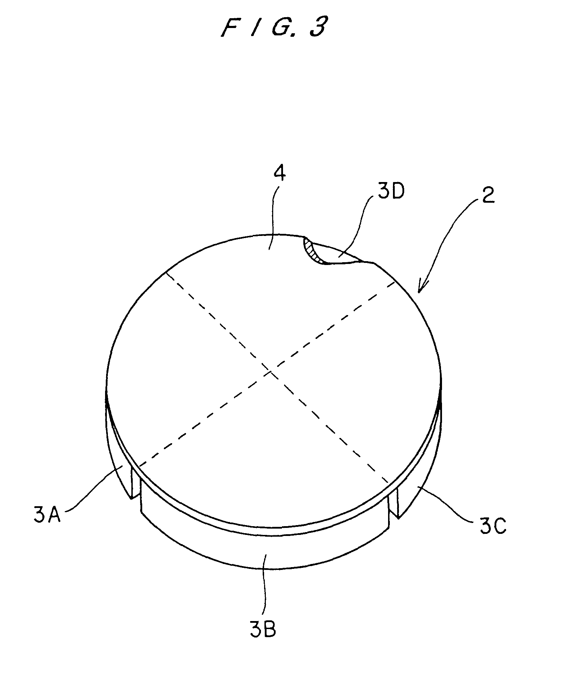

FIG. 3 shows a cloth cartridge in a polishing apparatus according to another embodiment of the present invention. As shown in FIG. 3, the cloth cartridge comprises four sectorial base plate segments 3A, 3B, 3C and 3D, and a circular sheet of polishing cloth 4 bonded to the upper surfaces of the base plate segments 3A, 3B, 3C and 3D. The cloth cartridge 2 of this embodiment, when replaced, can be folded along dotted lines in half or fourth. That is, the cloth cartridge 2 can be folded into a more compact form by utilizing flexibility of the polishing cloth 4. Therefore, the cloth cartridge of this embodiment can be easily handled, and can be contained in a small-sized bag as in the embodiment of FIG. 2.

In the above embodiment, the cloth cartridge comprises a plurality of base plate segments and a polishing cloth bonded to the upper surfaces of the base plate segments, and can be folded by utilizing flexibility of the polishing cloth. However, the polishing cloth may comprise a plurality of polishing cloth segments, and a connector such as a hinge may be provided between two base plate segments adjacent to each other so that the cloth cartridge can be folded in half or fourth. In case of a division-type cloth cartridge, it should be noted that the cloth cartridge may be handled by an individual unit comprising a base plate segment and a polishing cloth segment without folding, as described in the first embodiment.

As is apparent from the above description, the present invention offers the following advantages:

Since the cloth cartridge can be separated into a plurality of units or can be folded into a more compact form, the cloth cartridge can be easily handled at the time of replacement, and pollution of the environment of the clean room in which the polishing apparatus is installed can be prevented.

Although a certain preferred embodiment of the present invention has been shown and described in detail, it should be understood that various changes and modifications may be made therein without departing from the scope of the appended claims.

## Claims

1. A polishing apparatus for polishing a surface of a workpiece, comprising:
a turntable;
a cloth cartridge detachably exchangeably mounted on said turntable, said cloth cartridge including a cartridge base member and a polishing cloth bonded to an upper surface of said cartridge base member; and
a top ring for holding said workpiece and pressing said workpiece against said polishing cloth;
**characterised in that** said cartridge base member comprises a plurality of base member segments, and said polishing cloth comprises a plurality of polishing cloth segments bonded to upper surfaces of said base member segments, respectively.

2. A polishing apparatus according to claim 1, wherein said cloth cartridge is fixedly mounted on said turntable under vacuum.

3. A polishing apparatus according to claim 1, wherein said cartridge base member is made of one of alloy steel, aluminum and plastics as a main component.

4. A polishing apparatus according to claim 1, wherein said cloth cartridge is handled by an individual unit including one of said base member segments and one of said polishing cloth segments when replacing said cloth cartridge.

5. A polishing apparatus for polishing a surface of a workpiece, comprising:
a turntable;
a cloth cartridge detachably exchangeably mounted on said turntable, said cloth cartridge including a cartridge base member and a polishing cloth bonded to an upper surface of said cartridge base member; and
a top ring for holding said workpiece and pressing said workpiece against said polishing cloth;
**characterised in that** said cartridge base member comprises a plurality of base member segments, and said polishing cloth comprises a sheet of polishing cloth bonded to upper surfaces of said base member segments.

6. A polishing apparatus according to claim 5, wherein said cloth cartridge is fixedly mounted on said turntable under vacuum.

7. A polishing apparatus according to claim 5, wherein said cartridge base member is made of one of alloy steel, aluminum and plastics as a main component.

8. A polishing apparatus according to claim 5, wherein said cloth cartridge is handled by folding said cloth cartridge into a more compact form by utilizing flexibility of said polishing cloth.

9. A cloth cartridge to be detachably exchangeably mounted on a turntable of a polishing apparatus for use in polishing a surface of a workpiece, said cloth cartridge comprising:
a cartridge base member; and
a polishing cloth bonded to an upper surface of said cartridge base member;
**characterised in that** said cartridge base member comprises a plurality of base member segments, and said polishing cloth comprises a plurality of polishing cloth segments bonded to upper surfaces of said base member segments, respectively.

10. A cloth cartridge to be detachably exchangeably mounted on a turntable of a polishing apparatus for use in polishing a surface of a workpiece, said cloth cartridge comprising:
a cartridge base member; and
a polishing cloth bonded to an upper surface of said cartridge base member;
**characterised in that** said cartridge base member comprises a plurality of base member segments, and said polishing cloth comprises a sheet of polishing cloth bonded to upper surfaces of said base member segments.

## Patentansprüche

1. Poliervorrichtung zum Polieren einer Oberfläche des Werkstücks, wobei folgendes vorgesehen ist:
ein Drehtisch;
eine Tuchpatrone abnehmbar, austauschbar angebracht an dem Drehtisch, wobei die Tuchpatrone ein Patronenbasisglied aufweist und ein Poliertuch verbunden mit einer oberen Oberfläche (Oberseite) des Patronenbasisglieds; und
ein oberer Ring zum Halten des Werkstücks und zum Pressen des Werkstücks gegen das Poliertuch;
**dadurch gekennzeichnet, daß** das Patronenbasisglied eine Vielzahl von Basisgliedsegmenten aufweist, und das das Poliertuch eine Vielzahl von Poliertuchsegmenten aufweist, und zwar verbunden mit den jeweiligen Oberseiten der Basisgliedsegmente.

2. Poliervorrichtung nach Anspruch 1, wobei die Tuchpatrone an dem Drehtisch unter Vakuum fest angebracht ist.

3. Poliervorrichtung nach Anspruch 1, wobei das Patronenbasisglied aus einer einer Stahllegierung oder aus Aluminium oder aus Kunststoff als Hauptkomponente hergestellt ist.

4. Poliervorrichtung nach Anspruch 1, wobei die Tuchpatrone durch eine individuelle Einheit gehandhabt wird einschließlich eines der Basisgliedsegmente oder eines der Poliertuchsegmente, wenn die Tuchpatrone ersetzt wird.

5. Poliervorrichtung zum Polieren einer Oberfläche eines Werkstücks, wobei folgendes vorgesehen ist:
ein Drehtisch;
eine abnehmbar und austauschbar an dem Drehtisch angebrachte Tuchpatrone, die ein Patronenbasisglied und ein Poliertuch verbunden oder verklebt mit einer Oberseite des Patronenbasisglieds aufweist;
ein oberer Ring zum Halten des Werkstücks und zum Pressen des Werkstücks gegen das Poliertuch;
**dadurch gekennzeichnet, daß** das Patronenbasisglied eine Vielzahl von Basisgliedsegmenten aufweist und daß das Poliertuch einen Zuschnitt (Flächenelement) aus Poliertuch aufweist, und zwar verbunden bzw. verklebt mit den Oberseiten (Oberflächen) der Basisgliedsegmente.

6. Poliervorrichtung nach Anspruch 5, wobei die Tuchpatrone an dem Drehtisch unter Vakuum fest angebracht ist.

7. Poliervorrichtung nach Anspruch 5, wobei das Patronenbasisglied aus Stahllegierung oder Aluminium oder Kunststoff als Hauptkomponente hergestellt ist.

8. Poliervorrichtung nach Anspruch 5, wobei die Tuchpatrone gehandhabt wird durch Falten der Tuchpatrone in eine kompaktere Form unter Ausnutzung der Flexibilität des Poliertuches.

9. Tuchpatrone zur lösbaren, austauschbaren Anbringung an einem Drehtisch einer Poliervorrichtung zur Verwendung beim Polieren der Oberfläche eines Werkstücks wobei die Tuchpatrone folgendes aufweist:
ein Patronenbasisglied;
ein Poliertuch verbunden bzw. verklebt mit einer Oberfläche des Patronenbasisglieds,
**dadurch gekennzeichnet, daß** das Patronenbasisglied eine Vielzahl von Basisgliedssegmenten aufweist und wobei das Poliertuch eine Vielzahl von Poliertuchsegmenten aufweist, und zwar verbunden mit den oberen Oberflächen (Oberseiten) der entsprechenden Basisgliedsegmente.

10. Tuchpatrone zur lösbaren austauschbaren Anbringung an einem Drehtisch einer Poliervorrichtung zur Verwendung beim Polieren einer Oberfläche eines Werkstücks, wobei die Tuchpatrone folgendes aufweist:
ein Kasetten- oder Patronenbasisglied;
ein Poliertuch verbunden mit einer oberen Oberfläche (Oberseite) des Patronenbasisglieds;
**dadurch gekennzeichnet, daß** das Patronenbasisglied eine Vielzahl von Basisgliedsegmenten aufweist und wobei das Poliertuch einen Zuschnitt ( Flächenelement) aus Poliertuch aufweist, und zwar verbunden bzw. verklebt mit den Oberseiten der Basisgliedsegmente.

## Revendications

1. Dispositif de polissage destiné à polir une surface d'une pièce à usiner, comportant :
un plateau tournant,
une cartouche de tissu montée de manière amovible et de manière remplaçable sur ledit plateau tournant, ladite cartouche de tissu comportant un élément formant base de cartouche et un tissu de polissage collé sur une surface supérieure dudit élément formant base de cartouche, et
un anneau supérieur destiné à maintenir et à comprimer ladite pièce à usiner contre ledit tissu de polissage,
**caractérisé en ce que** ledit élément formant base de cartouche comporte une pluralité de segments d'élément de base, et ledit tissu de polissage comporte une pluralité de segments de tissu de polissage collés sur les surfaces supérieures desdits segments d'élément de base, respectivement.

2. Dispositif de polissage selon la revendication 1, dans lequel ladite cartouche de tissu est montée de manière fixe sur ledit plateau tournant, sous vide.

3. Dispositif de polissage selon la revendication 1, dans lequel ledit élément formant base de cartouche est constitué d'un élément parmi un acier allié, l'aluminium, et des matières plastiques en tant que composant principal.

4. Dispositif de polissage selon la revendication 1, dans lequel ladite cartouche de tissu est manipulée par une unité individuelle comportant un desdits segments d'élément formant base et un desdits segments de tissu de polissage lors du remplacement de ladite cartouche de tissu.

5. Dispositif de polissage destiné à polir une surface d'une pièce à usiner, comportant :
un plateau tournant,
une cartouche de tissu montée de manière amovible et de manière remplaçable sur ledit plateau tournant, ladite cartouche de tissu comportant un élément formant base de cartouche et un tissu de polissage collé sur une surface supérieure dudit élément formant base de cartouche, et
un anneau supérieur destiné à maintenir et à comprimer ladite pièce à usiner contre ledit tissu de polissage,
**caractérisé en ce que** ledit élément formant base de cartouche comporte une pluralité de segments d'élément formant base, et ledit tissu de polissage comporte une feuille de tissu de polissage collée sur les surfaces supérieures desdits segments d'élément formant base.

6. Dispositif de polissage selon la revendication 5, dans lequel ladite cartouche de tissu est montée de manière fixe sur ledit plateau tournant, sous vide.

7. Dispositif de polissage selon la revendication 5, dans lequel ledit élément formant base de cartouche est constitué d'un élément parmi un acier allié, l'aluminium, et des matières plastiques en tant que composant principal.

8. Dispositif de polissage selon la revendication 5, dans lequel ladite cartouche de tissu est manipulée en pliant ladite cartouche de tissu sous une forme plus compacte en utilisant la souplesse dudit tissu de polissage.

9. Cartouche de tissu devant être montée de manière amovible et de manière remplaçable sur un plateau tournant d'un dispositif de polissage destiné à être utilisé pour polir une surface d'une pièce à usiner, ladite cartouche de tissu comportant :
un élément formant base de cartouche, et
un tissu de polissage collé sur une surface supérieure dudit élément formant base de cartouche,
**caractérisée en ce que** ledit élément formant base de cartouche comporte une pluralité de segments d'élément formant base, et ledit tissu de polissage comporte une pluralité de segments de tissu de polissage collés sur les surfaces supérieures desdits segments d'élément formant base, respectivement.

10. Cartouche de tissu devant être montée de manière amovible et de manière remplaçable sur un plateau tournant d'un dispositif de polissage destiné à être utilisé pour polir une surface d'une pièce à usiner, ladite cartouche de tissu comportant :
un élément formant base de cartouche, et
un tissu de polissage collé sur une surface supérieure dudit élément formant base de cartouche,
**caractérisée en ce que** ledit élément formant base de cartouche comporte une pluralité de segments d'élément de base, et ledit tissu de polissage comporte une feuille de tissu de polissage collée sur les surfaces supérieures desdits segments d'élément formant base.
